Europäisches Patentamt

European Patent Office

Office européen des brevets

(11) Veröffentlichungsnummer: **0 325 150**
**A2**

## (12) EUROPÄISCHE PATENTANMELDUNG

(21) Anmeldenummer: 89100374.1

(22) Anmeldetag: 11.01.89

(51) Int. Cl.⁴: **G03F 3/10**

(30) Priorität: 19.01.88 DE 3801345

(43) Veröffentlichungstag der Anmeldung:
**26.07.89 Patentblatt 89/30**

(84) Benannte Vertragsstaaten:
**AT BE CH DE FR GB IT LI NL**

(71) Anmelder: **HOECHST AKTIENGESELLSCHAFT**
**Postfach 80 03 20**
**D-6230 Frankfurt am Main 80(DE)**

(72) Erfinder: **Gramm, Ine**
**Bingertstrasse 6**
**D-6200 Wiesbaden(DE)**
Erfinder: **Mohr, Dieter, Dr.**
**Eaubonner Strasse 8**
**D-6501 Budenheim(DE)**
Erfinder: **Haas, Dieter**
**Stettiner Strasse 15**
**D-6203 Hochheim(DE)**

(54) **Verfahren zur Herstellung eines Mehrfarbenbilds.**

(57) Es wird ein Verfahren zur Herstellung eines Mehrfarbenbilds beschrieben, bei dem man ein lichtempfindliches Material aus einem temporären Schichtträger (A), einer lichtempfindlichen Schicht (B), die einen Farbstoff oder ein Pigment einer bestimmten Grundfarbe enthält, und einer Haftschicht (C) auf der lichtempfindlichen Schicht unter Anwendung von Wärme und Druck auf ein Bildempfangsmaterial (D) laminiert, die Schicht unter dem zugehörigen Farbauszugsbild belichtet, den temporären Schichtträger (A) vor oder nach dem Belichten abzieht und die Schicht (B) durch Auswaschen der Nichtbildstellen zu einem ersten Teilfarbenbild entwickelt und bei dem man in gleicher Weise durch Übertragen, Belichten und Entwickeln auf dem Teilfarbenbild mindestens ein weiteres Teilfarbenbild in einer anderen Grundfarbe im Register zum ersten Teilfarbenbild erzeugt, wobei mindestens ein Teilfarbenbild aus einem negativ arbeitenden lichtempfindlichen Material und mindestens ein Teilfarbenbild aus einem positiv arbeitenden lichtempfindlichen Material hergestellt und die Entwicklung aller Teilfarbenbilder mit dem gleichen Entwickler durchgeführt wird. Das Verfahren erlaubt die Farbprüfung beim Mehrfarbendruck auch bei einem Satz Vorlagen, die Negativ- und Positivfarbauszüge enthalten.

EP 0 325 150 A2

## Verfahren zur Herstellung eines Mehrfarbenbilds

Im Mehrfarbendruck wird im allgemeinen eine Farbprüfung vorgenommen, um die Korrektur der für die Belichtung von Druckplatten verwendeten Farbauszüge zu ermöglichen. Das Prüfbild muß ein getreues Abbild des gewünschten Raster-oder Strichbildes sein und soll den Tonwert der Farben weder erhöht noch herabgesetzt wiedergeben. Die visuelle Farbprüfung soll Fehler in der Vorlage anzeigen, die beste Farbwiedergabe, die beim Drucken in der Druckmaschine von dem Material zu erwarten ist, ermöglichen, die genaue Gradation aller Farbtöne wiedergeben und soll die eventuelle Notwendigkeit zur Abschwächung einer der Farben angeben und/oder Hinweise zur Änderung der Filmvorlage vor der Herstellung der Druckplatten liefern.

Die Farbprüfung für den Mehrfarbendruck wird bisher mit Hilfe von Farbandrucken vorgenommen. Dabei müssen alle auch beim tatsächlichen Mehrfarbendruck notwendigen Schritte unternommen werden. Ein solches Farbprüfverfahren ist kostspielig und zeitaufwendig, und man hat deshalb andere Farbprüfverfahren entwickelt, die dem Andruck in der Qualität gleichkommen sollen. Zwei Farbprüfverfahren mittels lichtempfindlicher Farbprüffolien sind bekannt, nämlich das Surprint-Verfahren und das Overlay-Verfahren, bei denen Teilfarbenbilder erzeugt und entweder übereinanderkopiert oder übereinandergelegt werden.

Beim Farbprüfen nach dem Overlay-Verfahren wird auf jeweils einer transparenten Kunststoffolie von jedem Farbauszug für sich ein Teilfarbenbild hergestellt. Zur Herstellung eines Farbprüfsatzes werden dann mehrere solcher mit Teilfarbenbildern versehener transparenter Folien übereinander auf ein weißes Blatt gelegt. Das Overlay-Verfahren hat den Nachteil, daß die übereinanderliegenden Kunststoffträger dazu neigen, das Mehrfarbenbild dunkler zu machen, so daß der Eindruck, den man von dem so angefertigten Farbprüfsatz erhält, sich sehr stark von den Drucken unterscheidet, die man mit einem Farbandruck erzielt. Der Hauptvorteil dieses Verfahrens besteht darin, daß es schnell ist und durch passergenaues Kombinieren von jeweils zwei oder mehreren Teilfarbenbildern zur Prüfung von Korrekturmaßnahmen dienen kann.

Bei der Prüfung nach dem Surprint-Verfahren wird ein Farbprüfbild angefertigt, indem nacheinander Teilfarbenbilder in verschiedenen Farben von verschiedenen Farbauszügen auf einem einzigen Empfangsblatt hergestellt werden. Dazu wird ein undurchsichtiger Träger verwendet, auf den nacheinander lichtempfindliche Schichten in den entsprechenden Farben aufgebracht werden, wie es zum Beispiel in der US-A 3 671 236 beschrieben ist. Das Surprint-Verfahren hat den Vorteil, daß die Farbsättigung nicht durch übereinanderliegende Kunststoffträger beeinflußt wird. Dieses Verfahren kommt dem tatsächlichen Druck näher und vermeidet die dem Overlay-Verfahren eigene Farbverfälschung.

In der US-A 3 721 557 wird ein Verfahren zur Übertragung von Farbbildern beschrieben, bei dem zwischen der lichtempfindlichen Schicht und dem Träger eine Abziehschicht aufgebracht ist. Wenn die lichtempfindliche Schicht belichtet und entwickelt wird, werden die löslicheren Teile der Schicht selektiv entfernt, und es entsteht ein sichtbares Bild. Der Träger mit dem Bild wird gegen ein geeignetes klebstoffbeschichtetes Empfangsmaterial gepreßt und dann die Bildübertragung durch Abziehen des Trägers vorgenommen. Für jede weitere Bildübertragung wird eine frische Klebstoffschicht auf das Empfangsmaterial aufgetragen.

In der US-A 4 093 464 wird im Beispiel 1 ein Farbprüfverfahren beschrieben, bei dem positiv arbeitende lichtempfindliche Schichten, die in den gewünschten Grundfarben eingefärbt sind und sich jeweils auf einer temporären Trägerfolie befinden, auf dieser Folie belichtet und entwickelt werden. Die erhaltenen Teilfarbenbilder werden auf ein Bildempfangsmaterial, z. B. ein Bedruckpapier, durch Laminieren im Register übertragen. Diese Verfahren haben den Nachteil, daß das Laminieren im Register sehr präzises Arbeiten erfordert und deshalb sehr aufwendig ist. Auch läßt sich das Laminieren von entwickelten Bildern nur mit Schichten durchführen, die noch ausreichend thermoplastisch sind, also in der Regel nur mit positiv arbeitenden Schichten, die zudem noch bestimmte plastifizierende Zusätze enthalten.

In der US-A 4 260 673 wird zur Herstellung eines Mehrfarben-Prüfbilds ein mehrschichtiges Material aus einer gefärbten und einer ungefärbten lichtempfindlichen Positivschicht, einer Haft- und einer Trennschicht und einer temporären Trägerfolie auf ein Bildempfangsmaterial, das ein wasserfest ausgerüstetes weißes Papier ist, laminiert, dort belichtet und zum Teilfarbenbild entwickelt. Die übrigen Teilfarbenbilder werden über dem ersten in gleicher Weise erzeugt. Nach diesem Verfahren lassen sich passergenaue Mehrfarbenbilder leichter erhalten, da nur im Register belichtet zu werden braucht.

In der EP-A 182 031 wird ein ähnliches Surprint-Farbprüfverfahren beschrieben, bei dem lichtempfindliche Schichten auf Basis negativ arbeitender Diazoniumverbindungen verwendet werden. Als Bildempfangsmaterial dient eine weiß eingefärbte Polyesterfolie. Die Oberfläche des fertigen Bilds kann mattiert werden, um einen unerwünschten Glanz zu beseitigen. Ein entsprechendes Verfahren mit positiv arbeitenden Materialien ist in der EP-A 179 274 beschrieben.

Neuerdings wird nun durch die Verfügbarkeit von Umkehrplatten, d. h. lichtempfindlichen Positivdruckplatten, die durch eine besondere Folge von Behandlungsschritten auch zu negativen Bildern verarbeitet werden können, das Zusammenkopieren von Positiv- und Negativvorlagen auf ein und dieselbe Platte (Photocomposing) ermöglicht. Derartige Druckplatten sind z. B. in den EP-A 131 238 und 133 216 beschrieben. Diese Technik eröffnet vielfältige Möglichkeiten zum Zusammen- und Übereinanderkopieren von als Negativ- und Positivfilmmasken vorliegenden Bildelementen zu einem Gesamtbild auf der Druckplatte. Da diese Arbeitsmethode besonders bei der Herstellung von Mehrfarbendrucken mit Vorteil eingesetzt wird, besteht ein wachsendes Bedürfnis, durch ein Farbprüfsystem schon vor der Plattenkopie mit den entsprechenden Filmvorlagen das zu erwartende Druckbild simulieren zu können. Alle bisher bekannt gewordenen Farbprüfverfahren, wie sie in der graphischen Industrie eingesetzt werden, gehen aus vom Aufbau des Mehrfarbenbildes aus Teilfarbenbildern, welche entweder ausschließlich aus positiv arbeitenden lichtempfindlichen Materialien oder ausschließlich aus negativ arbeitenden lichtempfindlichen Materialien erzeugt werden. Damit ist es unmöglich, ein gedrucktes Mehrfarbenbild, welches mit durch Photocomposing erstellten Druckformen erzeugt wurde, unter Verwendung der gleichen Filmmasken bzw. -vorlagen wie zur Plattenkopie zu simulieren. Mit allen bisher beschriebenen Farbprüfverfahren können nur die als Positivfarbauszüge vorliegenden Bildelemente bzw. die als Negativfarbauszüge vorliegenden Bildelemente separat voneinander mittels eines positiv arbeitenden und eines negativ arbeitenden Farbprüfsystems hergestellt werden. Eine Beurteilung des Gesamtbildes ist folglich ausgeschlossen. Damit ist für diesen speziellen Anwendungsfall das Ziel aller Farbprüfverfahren, ein Mehrfarbbild zu erzeugen, das dem angestrebten Mehrfarbdruck in seinem Aussehen möglichst nahe kommt, nicht zu erreichen.

Der Weg, analog zur Erstellung der Druckformen ein Teilfarbenbild auf einer positiv arbeitenden Farbprüffolie durch Photocomposing und Umkehrentwicklung aus Negativ- und Positivvorlagen zu kombinieren, ist deshalb nicht gangbar, weil Schichtträger und Zwischen-oder Haftschichten, wie sie beim Surprint-Verfahren erforderlich sind, das bei der Umkehrentwicklung erforderliche Erhitzen nicht ohne Schaden überstehen.

Aufgabe der Erfindung war es, ein Farbprüfverfahren vorzuschlagen, bei dem das Mehrfarbenbild, entsprechend der Bebilderung der Platte nach der Photocomposing-Methode, aus positiv und negativ bebilderten Bildelementen registergenau aufgebaut wird und bei dem alle Teilfarbenbilder mit den gleichen Verarbeitungshilfsmitteln, insbesondere Entwicklern, hergestellt werden können.

Erfindungsgemäß wird ein Verfahren zur Herstellung eines Mehrfarbbildes vorgeschlagen, bei dem man ein lichtempfindliches Material aus einem temporären Schichtträger (A), einer lichtempfindlichen Schicht (B), die einen Farbstoff oder ein Pigment einer bestimmten Grundfarbe enthält, und einer Haftschicht (C) auf der lichtempfindlichen Schicht unter Anwendung von Wärme und Druck auf ein Bildempfangsmaterial (D) laminiert, die Schicht unter dem zugehörigen Farbauszugs bild belichtet, den temporären Schichtträger (A) vor oder nach dem Belichten abzieht und die Schicht (B) durch Auswaschen der Nichtbildstellen zu einem ersten Teilfarbenbild entwickelt und bei dem man in gleicher Weise durch Übertragen, Belichten und Entwickeln auf dem Teilfarbenbild mindestens ein weiteres Teilfarbenbild in einer anderen Grundfarbe im Register zum ersten Teilfarbenbild erzeugt.

Das erfindungsgemäße Verfahren ist dadurch gekennzeichnet, daß man mindestens ein Teilfarbenbild aus einem negativ arbeitenden lichtempfindlichen Material und mindestens ein Teilfarbenbild aus einem positiv arbeitenden lichtempfindlichen Material herstellt und die Entwicklung aller Teilfarbenbilder mit dem gleichen Entwickler durchführt.

Nach dem erfindungsgemäßen Verfahren wird das endgültige Mehrfarbenbild auf dem Bildempfangsmaterial D in beliebiger Reihenfolge aus den Teilfarbenbildern der positiv und negativ erzeugten Bildelemente aufgebaut.

Zur Durchführung des erfindungsgemäßen Verfahrens wird ein lichtempfindliches Material eingesetzt, das generell aus einem temporären Träger mit einer wenig haftenden Oberfläche, einer farbigen lichtempfindlichen Schicht auf der Oberfläche und einer Haft- bzw. Klebeschicht auf der lichtempfindlichen Schicht besteht. Gegebenenfalls können auch noch weitere Schichten verwendet werden, die Lichthofschutzmittel, Haftvermittler oder Trennmittel enthalten.

In bevorzugter Ausführung besteht der Schichtträger aus einer maßbeständigen und chemisch stabilen Polyesterfolie, insbesondere aus Polyethylenterephthalat, die normalerweise eine Dicke von etwa 25 - 250 $\mu$m, vorzugsweise etwa 50 - 130 $\mu$m und insbesondere etwa 50 - 75 $\mu$m aufweist. Die Oberfläche des temporären Schichtträgers kann glatt sein oder eine rauhe Struktur haben.

Im allgemeinen besteht die lichtempfindliche Schicht des lichtempfindlichen Materials aus einer lichtempfindlichen Verbindung, einem Farbmittel, einem Bindemittel und gegebenenfalls weiteren Bestandteilen, z. B. Weichmachern, sauren Stabilisatoren, Tensiden, Antistatika, UV-Absorbern und Lösemittelresten.

Als positiv arbeitende lichtempfindliche Verbindungen sind insbesondere o-Chinondiazide geeignet, z.

3

B. Ester von 1,2-Naphthochinon-2-diazid-5-sulfonsäure und mehrwertigen Phenolen, z. B. 2,3,4-Trihydroxy-benzophenon oder dem Umsetzungsprodukt von 2 mol dieser Verbindung mit 1 mol Formaldehyd. Derartige Verbindungen sind in den US-A 4 407 426, 4 266 001, 3 106 365, 3 148 983 und 3 201 239 beschrieben. Bevorzugt werden Verbindungen, die in organischen Lösemitteln löslich sind.

Als lichtempfindliche Verbindungen für negativ arbeitende Materialien werden vorzugsweise Diazoniumsalz-Polykondensationsprodukte verwendet. Am meisten bevorzugt werden Polykondensationsprodukte, wie sie in der US-A 3 849 392 beschrieben sind. Weitere geeignete Verbindungen sind in der US-A 4 436 804 genannt. Die gewählten Diazoniumverbindungen sind bevorzugt in organischen Lösemitteln löslich.

Als Bindemittel für Positiv- und Negativschichten geeignete Harze sind Polyvinylacetale, z. B. Polyvinylbutyral, und alkalilösliche Polymere, wie Styrol/Maleinsäurehalbester-Copolymere oder Mischungen daraus. Solche Harze sind beispielsweise Butvar B 72, B 76 und B 90 und Scripset 540 bzw. 550, die alle von Monsanto hergestellt werden. Ein wichtiges Kriterium bei der Wahl des Harzes ist, daß es gute Filmbildungseigenschaften haben muß.

Zu den erfindungsgemäß geeigneten Farbmitteln zählen verschiedene Farbstoffe und Pigmente. In der am meisten bevorzugten Ausführung werden Pigmente mit einer durchschnittlichen Teilchengröße von höchstens etwa 1 μm eingesetzt.

Der lichtempfindlichen Schicht können gegebenenfalls Weichmacher vom Phthalat- oder Phosphattyp zugesetzt werden. Bevorzugte Weichmacher sind Dibutylphthalat und Dimethylphthalat. Geeignete saure Stabilisatoren sind z. B. Phosphorsäure und p-Toluolsulfonsäure.

Diese Komponenten können in verträglichen Lösemitteln wie Ethanol, 2-Methoxy-ethanol, Diacetonalkohol, Butyrolacton, Propylenglykolmonomethylether oder Buta non gelöst auf die Trägeroberfläche aufgetragen und getrocknet werden. Die trockene lichtempfindliche Schicht hat vorzugsweise ein Schichtgewicht von 0,1 bis 5,0, insbesondere von 0,5 bis 2,0 g/m$^2$.

Die positiv arbeitenden Schichten enthalten bvorzugt 15 bis 60, insbesondere 20 bis 50 Gew.-% lichtempfindliche Verbindung; 10 bis 40, insbesondere 13 bis 34 Gew.-% Farbmittel; 20 bis 75, insbesondere 30 bis 70 Gew.-% Bindemittel und bis zu etwa 20, vorzugsweise bis zu 15 und insbesondere 12 bis 15 Gew.-% Weichmacher.

Typische Zusammensetzungen in Gewichtsteilen für die positiv arbeitenden lichtempfindlichen Beschichtungslösungen sind die folgenden:

| | Cyan $(P_c)$ | Gelb $(P_g)$ | Magenta $(P_m)$ | Schwarz $(P_s)$ |
|---|---|---|---|---|
| Diacetonalkohol | - | 11,7 | - | - |
| Butanon | 35,52 | 34,45 | 24,23 | 38,62 |
| Butyrolacton | 22,60 | 11,15 | 24,04 | 5,74 |
| Propylenglykolmonomethylether | 34,76 | 35,21 | 44,94 | 48,34 |
| Styrol/Maleinsäurepartialester-Misch-polymerisat ($M_n$-50 000; Säurezahl 185; Scripset 540) | 1,60 | 2,01 | 2,15 | 2,39 |
| Styrol/Maleinsäureanhydrid/Maleinsäure-partialester-Mischpolymerisat; MG 1900; SZ 220 (SMA 2625) | 1,74 | 1,17 | - | 0,60 |
| Polyvinylbutyral $M_w$ 40 000; 80 % Vinyl-butyral-, 19 % Vinylalkohol-, 1 % Vinylacetateinheiten (Butvar B 90) | 0,58 | 0,59 | 0,67 | 0,30 |

| | Cyan ($P_c$) | Gelb ($P_g$) | Magenta ($P_m$) | Schwarz ($P_s$) |
|---|---|---|---|---|
| Ester aus 6 mol 1,2-Naphthochinon-2-diazid-5-sulfonsäure und 1 mol Bis-(5-benzoyl-2,3,4-trihydroxy-phenyl)methan | 2,09 | 2,58 | 2,81 | 2,72 |
| Phthalocyaninblau | 1,11 | - | - | - |
| gelbes Pigment | - | 1,08 | - | - |
| Magenta-Pigment | - | - | 1,15 | - |
| schwarzes Pigment | - | - | - | 1,29 |
| optische Dichte | 1,2 | 1,0 | 1,4 | 1,6 |

In den negativ arbeitenden Schichten sind die Komponenten vorzugsweise in folgenden Anteilen enthalten: die lichtempfindliche Verbindung von etwa 5 bis 40 Gew.-%, insbesondere von etwa 10 bis 35 Gew.-%, das Farbmittel von etwa 10 bis 40 Gew.-%, insbesondere von etwa 13 bis 34 Gew.-%, das Bindemittel von etwa 25 bis 80 Gew.-%, insbesondere von etwa 32 bis 75 Gew.-%, der gegebenenfalls verwendete Weichmacher bis zu etwa 20 Gew.-%, vorzugsweise bis zu etwa 15 Gew.-% und insbesondere von etwa 12 bis 15 Gew.-%, und der gegebenenfalls verwendete saure Stabilisator bis zu etwa 10 Gew.-%.

Nachfolgend sind zwei typische Zusammensetzungen für die lichtempfindlichen Negativschichten angegeben:

I.

| | Cyan ($NI_c$) | Gelb ($NI_g$) | Schwarz ($NI_s$) |
|---|---|---|---|
| 2-Methoxy-ethanol | 27,37 | 62,16 | 58,35 |
| Butanon | 40,30 | 33,00 | 35,65 |
| Ethanol | 27,20 | - | - |

|  | Cyan ($NI_c$) | Gelb ($NI_g$) | Schwarz ($NI_g$) |
|---|---|---|---|
| konz. Phosphorsäure | 0,40 | – | 0,50 |
| p-Toluolsulfonsäure | – | 0,25 | – |
| Dibutylphthalat | – | – | 0,75 |
| Polyvinylbutyral, $M_w$ 225 000, 80 % Vinyl-butyral-, 18 % Vinylalkohol-, 2 % Vinyl-acetateinheiten (Butvar 72) | 1,08 | 1,62 | 1,125 |
| Butvar 90 | 0,60 | 0,80 | 1,50 |
| Diazoniumverbindung *) | 1,70 | 0,55 | 1,00 |
| Phthalocyaninblau | 1,35 | – | – |
| gelbes Pigment | – | 1,62 | – |
| schwarzes Pigment | – | – | 1,125 |
| optische Dichte | 1,2 | 0,9 | 1,3 |

*) Polykondensationsprodukt aus 3-Methoxy-diphenylamin-4-diazonium-salz und 4,4'-Bis-methoxymethyl-diphenylether

| II. | Cyan ($NII_c$) | Gelb ($NII_g$) | Magenta ($NII_m$) | Schwarz ($NII_s$) |
|---|---|---|---|---|
| 2-Methoxy-ethanol | 41,00 | 41,00 | 46,50 | 41,00 |
| Butanon | 41,00 | 40,99 | 46,48 | 41,00 |
| Butyrolacton | 10,00 | 10,00 | – | 10,00 |
| Dimethylphthalat | 0,75 | 0,75 | 0,88 | 0,75 |
| Dibutylphthalat | 0,25 | 0,25 | – | 0,25 |
| p-Toluolsulfonsäure | – | – | 0,18 | 0,35 |
| Scripset 540 | 3,33 | 2,60 | 3,15 | 3,71 |
| Maleinsäurepartialester/Styrol-Mischpolymerisat; $M_n$=45 000; SZ 175 (Scripset 550) | 1,17 | – | – | – |
| hydrolysiertes Scripset 540 | – | – | 0,67 | – |
| SMA 2625 | – | 2,02 | – | – |

| II. (Fortsetzung) | Cyan (NII$_c$) | Gelb (NII$_g$) | Magenta (NII$_m$) | Schwarz (NII$_s$) |
|---|---|---|---|---|
| Diazoniumverbindung wie bei I | 1,33 | 1,35 | 0,70 | 2,00 |
| Phthalocyaninblau | 1,17 | - | - | - |
| gelbes Pigment | - | 1,04 | - | - |
| Magentapigment | - | - | 1,44 | - |
| schwarzes Pigment | - | - | - | 0,94 |
| optische Dichte | 1,1 | 0,9 | 1,2 | 1,5 |

Die Haftschicht besteht vorwiegend aus Polyvinylacetat. Beispiele für geeignete Polyvinylacetate sind Mowilith 20, 25, 30, DM 6, DM 22 und Mischungen daraus (Hersteller Hoechst AG). Die Polyvinylacetate werden gewöhnlich in Wasser dispergiert oder in einem organischen Lösemittel gelöst und auf die lichtempfindliche Schicht aufgebracht. Die Schicht wird dann getrocknet, so daß sich ein Schichtgewicht von etwa 5 bis 30 g/m², bevorzugt von etwa 10 bis 20 g/m² ergibt. In der Schicht können gegebenenfalls UV-Absorber, z. B. Uvinul D-50 (Hersteller GAF), Weichmacher, z. B. Resoflex R-296 (Hersteller Cambridge Industries) sowie Antistatika, z. B. Gafac und Gafstat (Hersteller GAF) und weitere Harze, z. B. Nitrocellulose R 1/2 (Hersteller Hercules) enthalten sein. Während der Lagerung oder Entwicklung des lichtempfindlichen Materials soll sich die Haftschicht nicht klebrig anfühlen. Die Schicht soll bevorzugt einen Erweichungspunkt im Bereich von etwa 60 - 120° C, insbesondere von 60 - 100° C, haben. In bevorzugter Ausführung ist das Polyvinylacetat in einem Anteil von mehr als 50 Gew.-% in der Haftschicht enthalten. Der Weichmacher kann in einem Anteil von bis zu etwa 30 Gew.-%, der UV-Absorber bis zu etwa 20 Gew.-% und andere Harze bis zu etwa 50 Gew.-% in der Schicht anwesend sein.

Die Haftschicht kann zum Beispiel eine der folgenden Zusammensetzungen (Gew.-%) haben:

| H I. | Wasser | 50 | (Terpolymeres aus Vinylacetat/Vinylester einer langkettigen Carbonsäure/Acrylsäureester) |
| | Mowilith DM-22 (50 %ige wäßrige Dispersion) | 50 | |
| H II. | n-Butylacetat | 78 | |
| | Resoflex R-296 | 1 | |
| | Mowilith 25 | 21 | (Polyvinylacetat, MG 100.000) |
| H III. | Isopropylacetat | 70 | |
| | Mowilith 30 | 30,0 | (Polyvinylacetat, MG 110.000) |
| H IV. | Isopropylacetat | 49 | |
| | Cyclohexan | 21 | |
| | Mowilith 25 | 30 | |

Bei der praktischen Anwendung wird das lichtempfindliche Material mit der Haftschicht auf ein Empfangsblatt laminiert. Das Empfangsblatt soll beständig gegen irgendwelche Beeinträchtigungen durch den gewählten Entwickler sein. Bei Verwendung von wäßrigen Entwicklern soll es zum Beispiel wasserfest sein. Für diesen Zweck sind Kunststoffolien oder kunststoffbeschichtete Papiere geeignet. Es können aber auch andere weiße und nicht-weiße Empfangsmaterialien verwendet werden. Die Oberfläche des Empfangsmaterials hat vorzugsweise eine rauhe Struktur und/oder ist haftvermittelnd behandelt worden, und sie muß unempfindlich gegen die Laminier- und Entwicklungsvorgänge sein.

Das Laminieren kann so durchgeführt werden, daß das Empfangsblatt mit der Haftschicht des farbigen lichtempfindlichen Materials in Kontakt gebracht wird und dann beide Materialien unter entsprechendem Druck zusammen durch den Walzenspalt eines beheizten Laminierwalzenpaares geführt werden. Geeignete Laminiertemperaturen liegen im allgemeinen bei etwa 60 - 120, zweckmäßig 60 - 90° C, vorzugsweise bei 75 - 85° C. Nach dem Laminieren wird der Träger abgezogen, was normalerweise einfach von Hand geschieht. Die Haftschicht und die lichtempfindliche Schicht bleiben dabei auf dem Empfangsblatt zurück.

Die lichtempfindliche Schicht wird entweder vor oder nach dem Laminieren in bekannter Weise bildmäßig belichtet. Sie kann z. B. mit einer UV-Lichtquelle durch eine Photomaske im Vakuumkopierrahmen belichtet werden. Damit die Schichten bei der Belichtung miteinander im Kontakt sind, wird vorzugsweise nach dem Laminieren und Abziehen der Trägerfolie belichtet. Quecksilberdampflampen werden gegenüber Metallhalogenidlampen bevorzugt. Es können auch Filter verwendet werden, um die Lichtstreuung zu reduzieren.

Nach dem Laminieren, Abziehen der Trägerfolie und Belichten wird die lichtempfindliche Schicht entwickelt, indem die Nichtbildbereiche in einem geeigneten Entwickler gelöst werden. Anschließend wird getrocknet. Die Haftschicht wird beim Entwickeln nicht entfernt.

Geeignete Entwickler für die positiv und negativ arbeitenden Schichten sind wäßrige Lösungen von Natrium-, Lithium- und Kaliumsalzen schwacher Säuren und die in der US-A 4 436 807 beschriebenen Entwickler. Die Haftschicht wird durch den Entwickler nicht wesentlich angegriffen. Geeignete Entwickler haben beispielsweise folgende Zusammensetzung:

| E | Wasser | 95,0 |
| I. | Natriumdecylsulfat | 3,0 |
| | Dinatriumphosphat | 1,5 |
| | Natriummetasilicat | 0,5 |
| E | Wasser | 89,264 |
| II. | Mononatriumphosphat | 0,269 |
| | Trinatriumphosphat | 2,230 |
| | Natriumtetradecylsulfat | 8,237 |

Es kann jede Entwicklerlösung verwendet werden, die die Nichtbildbereiche beider lichtempfindlicher Schichttypen einwandfrei entfernt und die Bildstellen zurückläßt.

Der Vorgang kann dann wiederholt werden, wobei ein weiteres lichtempfindliches Material in einer anderen Farbe über das zuvor hergestellte Bild auf dasselbe Empfangsblatt laminiert wird. Um die komplette Farbwiedergabe eines gewünschten Bildes zu erhalten, werden normalerweise vier farbige Schichten verwendet. Diese Farbschichten umfassen Cyan (Blaugrün), Magenta (Purpur), Gelb und Schwarz.

Die Erfindung wird durch die folgenden Beispiele näher erläutert, in denen alle Prozent- und Mengenangaben, wenn nichts anderes gesagt ist, in Gewichtseinheiten zu verstehen sind.

Beispiel 1

Dieses Beispiel zeigt die Herstellung eines Farbprüfbilds aus einem Vierfarben-Rasterbild mit einkopiertem Text.

A) Durch Beschichten von 75 μm dicken biaxial verstreckten und thermofixierten transparenten Polyethylenterephthalatfolien mit jeweils einer der Lösungen $P_c$, $P_g$, $P_m$ und $P_s$, Trocknen und Überschichten der lichtempfindlichen Farbschicht mit einer Haftschicht von 15 μm Dicke aus Lösung H II werden vier lichtempfindliche Farbprüffolien hergestellt. Dann wird die Folie mit der Schicht $P_c$ unter Druck und Wärme in einem handelsüblichen Laminiergerät auf eine Bildempfangsfolie aus weißem, opakem, maßbeständigem Kunststoff laminiert, unter dem entsprechenden Farbauszug belichtet und nach Abziehen der Trägerfolie mit der Lösung E I entwickelt. Auf dem erhaltenen Teilfarbenbild wird durch Laminieren, Belichten im Register und Entwickeln das Teilfarbenbild der Farbe Magenta erzeugt. In gleicher Weise werden die Bilder in den Farben Gelb und Schwarz aufgebracht.

Eine negativ arbeitende Farbprüffolie der Farbe Schwarz wird durch Beschichten einer temporären Trägerfolie der oben angegebenen Beschaffenheit mit Lösung N $I_s$ und Haftschichtlösung H II hergestellt und auf das zuvor erhaltene Vierfarbenbild laminiert. Durch Belichten unter einer Negativ- Textvorlage, Abziehen der Trägerfolie und Entwickeln mit der Lösung E I wird ein Vierfarbenbild mit einkopiertem Text erhalten.

B) In entsprechender Weise kann ein Vierfarben-Rasterbild aus Negativ-Farbprüffolien mit einer Texteinlage aus einer schwarzen Positiv-Farbprüffolie erhalten werden.

Vier verschiedene Negativ-Farbprüffolien werden durch Beschichten des unter A angegebenen temporären Schichtträgers mit den Lösungen $NII_c$, $NII_m$, $NII_g$ und $NII_s$ und jeweils Überschichten mit der Haftschichtlösung H III hergestellt. Das Vierfarben-Rasterbild wird unter Verwendung von Negativ-Farbauszügen analog wie das Positivbild hergestellt, wobei als Entwickler die Lösung E II eingesetzt wird.

Für die Textkopie wird eine schwarze Positiv-Farbprüffolie (P$_s$) eingesetzt und mit dem gleichen Entwickler (E II) verarbeitet.

## Beispiel 2

Dieses Beispiel zeigt die Herstellung eines Vierfarben-Prüfbilds, bei dem in die dunklen Stellen eines Vierfarben-Rasterbilds ein Text in transparenten Buchstaben und in die hellen Stellen des Bilds ein Text in schwarzen Buchstaben oder in die dunklen und hellen Stellen ein Text in einer kontrastierenden Farbe einkopiert ist.

A) Wie in Beispiel 1 A beschrieben, werden vier lichtempfindliche Positiv-Farbprüffolien auf temporären Trägerfolien hergestellt. Dabei wird auf die Cyanschicht die Haftschicht H IV, auf die übrigen die Haftschicht H III aufgebracht. Die Cyanfolie wird wie dort laminiert und unter dem Raster-Farbauszug belichtet. Eine zweite Belichtung erfolgt durch eine Negativ-Textvorlage. Nach dem Entwickeln mit Entwickler E II werden in entsprechender Weise die Positiv-Teilfarbenbilder in den Farben Magenta, Gelb und Schwarz hergetellt, wobei jeweils eine Zweitbelichtung unter der gleichen Textvorlage wie bei dem Cyan-Teilfarbenbild vorgenommen wird. Es wird ein Vierfarbenbild mit transparenter Texteinlage erhalten. Darauf wird, wie in Beispiel 1 A, eine Negativ-Farbprüffolie der Farbe Schwarz, jedoch mit der Farbschicht NII$_s$ und der Haftschicht H IV laminiert und unter der Negativ-Textvorlage belichtet, deren transparente Textteile im Bereich der dunklen Partien des Rasterbilds abgedeckt werden. Die Schicht wird mit dem gleichen Entwickler wie das Rasterbild (E II) entwickelt. Auf diese Weise wird ein Vierfarbenbild mit hellen und dunklen Textstellen erhalten.

B) In entsprechender Weise wie unter A beschrieben wird ein Vierfarben-Rasterbild aus Negativ-Farbprüffolien mit einer Texteinlage aus einer schwarzen Positiv-Farbprüffolie hergestellt.

Es werden vier verschiedene Negativ-Farbprüffolien durch Beschichten des in Beispiel 1A angegebenen temporären Schichtträgers mit den Farbschichten NII$_c$, NII$_m$, NII$_g$ und NII$_s$ und Überschichten mit der Haftschicht HII hergestellt. Das Vierfarben-Rasterbild wird durch Belichten unter den entsprechenden Negativ-Farbauszügen jeweils zusammen mit der gleichen Positiv-Textvorlage, analog wie das Positivbild hergestellt, wobei als Entwickler die Lösung E I verwendet wird.

Für die Textkopie wird eine schwarze Positiv-Farbprüffolie mit der lichtempfindlichen Schicht P$_s$ und der Haftschicht H II eingesetzt und unter der vorstehend genannten Positiv-Textvorlage belichtet. Eine zweite Belichtung erfolgt, indem die Schicht in den hellen Bereichen des Rasterbilds abgedeckt wird und die in den dunklen Bereichen liegenden Textstellen ausbelichtet werden. Nach Entwickeln mit dem Entwickler E I erhält man ein Vierfarbenbild mit transparenten und schwarzen Textstellen.

C) Auf ein Vierfarben-Rasterbild, das wie unter A beschrieben erhalten worden ist, wird eine negativ arbeitende Cyan-Farbprüffolie mit der Farbschicht NII$_c$ und der Haftschicht H II laminiert, unter der dort verwendeten Negativ-Textvorlage belichtet und mit dem Entwickler E II entwickelt. Das gleiche wird mit einer Farbprüffolie der Farbe Gelb (NII$_g$ + HII) wiederholt. Es wird ein Vierfarbenbild mit grünen Textstellen in den ausgesparten Bildstellen erhalten.

D) Auf ein Vierfarben-Rasterbild, das wie unter B beschrieben erhalten worden ist, wird eine positiv arbeitende Cyan-Farbprüffolie mit der Farbschicht P$_c$ und der Haftschicht H III laminiert, unter der zuvor verwendeten Positiv-Textvorlage belichtet und mit dem Entwickler E II entwickelt. In gleicher Weise wird eine Positiv-Farbprüffolie der Farbe Gelb (P$_g$ + H III) laminiert, belichtet und entwickelt. Es wird ein Vierfarben-Rasterbild mit grünen Texteinlagen erhalten.

## Beispiel 3

In diesem Beispiel wird das Zusammenkopieren eines Positiv-Rasterbilds mit einem Negativ-Rasterbild aus Ein- oder Mehrfarbenauszügen beschrieben.

Auf eine Bildempfangsfolie aus weißem, opakem, maßbeständigem Kunststoff wird eine positiv arbeitende Farbprüffolie der Farbe Cyan (P$_c$ und H I) unter Druck und Erwärmen laminiert und dann unter dem Positiv-Cyanauszug belichtet. Mittels einer zweiten Belichtung der Cyan-Positivschicht durch eine geeignete Negativmaske können unerwünschte Bildbereiche des Positivbilds wegbelichtet werden, und damit kann ein bildfreier Bereich für das spätere Einkopieren eines negativ erzeugten Bilds geschaffen werden. Nach der zweiten Belichtung wird das Teilfarbenbild mit dem Entwickler E II entwickelt. Besteht die diesem Bild zugrundeliegende Vorlage aus mehreren Farben, so wird das Mehrfarbenbild wie in Beispiel 2 A beschrieben weiter aufgebaut. Auf das erhaltene Mehrfarben-Rasterbild wird dann eine negativ arbeitende Farbprüffolie der Farbe Cyan (NII$_c$ + H 1) laminiert. Wie in Beispiel 1 B beschrieben, wird dann aus dieser und weiteren Farbprüffolien der Farben Magenta (NII$_m$ + H I), Gelb (NII$_g$ + H I) und Schwarz (NII$_s$ + H I) ein Vierfarbenbild aufgebaut. Auf diese Weise wird ein aus einer oder mehreren Farben bestehendes Bild von einer Positivvorlage mit einem aus einer oder mehreren Farben bestehenden Bild von einer Negativvorlage zusammenkopiert.

Beispiel 4

Dieses Beispiel zeigt das Zusammenkopieren eines positiven und eines negativen Rasterbilds aus Ein- oder Mehrfarbenauszügen mit Textteilen, die ein - oder mehrfarbig sein können.

Wie im Beispiel 3 beschrieben, wird auf einem Bildempfangsmaterial ein Positiv- und ein Negativ-Mehrfarbenbild aufgebaut. In das Bild kann ein Text eingefügt werden, indem man wie in Beispiel 1 B auf das fertige Rasterbild eine positiv arbeitende Farbprüffolie der Farbe Schwarz (P$_s$ + H III) laminiert, unter einer Positiv-Textvorlage belichtet und entwickelt. Alternativ kann auch entsprechend Beispiel 2 D ein Text einkopiert werden, der aus einer Mischfarbe besteht. Auf diese Weise entsteht ein Bild, das aus einer positiven und einer negativen Rastervorlage zusammenkopiert worden ist und zusätzlich eine farbige oder schwarze Texteinlage enthält.

**Ansprüche**

1. Verfahren zur Herstellung eines Mehrfarbenbilds, bei dem man ein lichtempfindliches Material aus einem temporären Schichtträger (A), einer lichtempfindlichen Schicht (B), die einen Farbstoff oder ein Pigment einer bestimmten Grundfarbe enthält, und einer Haftschicht (C) auf der lichtempfindlichen Schicht unter Anwendung von Wärme und Druck auf ein Bildempfangsmaterial (D) laminiert, die Schicht unter dem zugehörigen Farbauszugsbild belichtet, den temporären Schichtträger (A) vor oder nach dem Belichten abzieht und die Schicht (B) durch Auswaschen der Nichtbildstellen zu einem ersten Teilfarbenbild entwickelt und bei dem man in gleicher Weise durch Übertragen, Belichten und Entwickeln auf dem Teilfarbenbild mindestens ein weiteres Teilfarbenbild in einer anderen Grundfarbe im Register zum ersten Teilfarbenbild erzeugt, dadurch gekennzeichnet, daß man mindestens ein Teilfarbenbild aus einem negativ arbeitenden lichtempfindlichen Material und mindestens ein Teilfarbenbild aus einem positiv arbeitenden lichtempfindlichen Material herstellt und die Entwicklung aller Teilfarbenbilder mit dem gleichen Entwickler durchführt.

2. Verfahren nach Anspruch 1, dadurch gekennzeichnet, daß man ein positiv arbeitendes lichtempfindliches Material, das als lichtempfindliche Verbindung ein 1,2-Naphthochinondiazid enthält, und ein negativ arbeitendes lichtempfindliches Material einsetzt, das als lichtempfindliche Verbindung ein Diazonium-salz-Polykondensationsprodukt enthält.

3. Verfahren nach Anspruch 2, dadurch gekennzeichnet, daß das positiv arbeitende lichtempfindliche Material in der lichtempfindlichen Schicht ferner ein alkalilösliches Bindemittel enthält.

4. Verfahren nach Anspruch 2, dadurch gekennzeichnet, daß das negativ arbeitende lichtempfindliche Material in der lichtempfindlichen Schicht ferner ein polymeres Bindemittel solcher Art und Menge enthält, daß sich die Schicht mit einer wäßrigen Lösung entwickeln läßt.

5. Verfahren nach Anspruch 1, dadurch gekennzeichnet, daß man als Entwickler eine wäßrig-alkalische Lösung einsetzt.

6. Verfahren nach Anspruch 5, dadurch gekennzeichnet, daß die Entwicklerlösung zusätzlich ein oberflächenaktives Mittel enthält.

7. Verfahren nach Anspruch 1, dadurch gekennzeichnet, daß man mindestens ein Teilfarbenbild auf einem positiv arbeitenden Material dadurch erzeugt, daß man das lichtempfindliche Material einmal unter einer Positivvorlage und ein weiteres Mal zur Erzeugung weiterer Bildelemente unter einer Negativvorlage belichtet und dann entwickelt.